## Europäisches Patentamt

## European Patent Office

## Office européen des brevets

(11) Veröffentlichungsnummer: **0 205 762**
**B1**

(12) # EUROPÄISCHE PATENTSCHRIFT

(45) Veröffentlichungstag der Patentschrift:
**17.11.88**

(51) Int. Cl.⁴: **C 23 C 14/06**

(21) Anmeldenummer: **86103328.0**

(22) Anmeldetag: **12.03.86**

(54) **Verfahren zum Aufbringen einer MoS2-Beschichtung auf ein Substrat.**

(30) Priorität: **10.05.85 DE 3516933**

(43) Veröffentlichungstag der Anmeldung:
**30.12.86 Patentblatt 86/52**

(45) Bekanntmachung des Hinweises auf die Patenterteilung:
**17.11.88 Patentblatt 88/46**

(84) Benannte Vertragsstaaten:
**CH FR GB LI**

(56) Entgegenhaltungen:
THIN SOLID FILMS, Band 53, Nr. 3, September 1978, Seiten 285-299, Elsevier Sequoia SA, Lausanne, CH, printed in NL; T. SPALVINS: "Coatings for wear and lubrication"
JAPANESE JOURNAL OF APPLIED PHYSICS, Band 10, Nr. 1, Januar 1971, Seiten 11-17, Tokyo, JP; S. NAGATA et al.: "Structure of film prepared by low energy sputtering of molybdenum"
CHEMICAL ABSTRACTS, Band 100, Nr. 2, Januar 1984, Seite 271, Zusammenfassung Nr. 11122a, Columbus, Ohio, US; V. BUCK: "Morphological properties of sputtered molybdenum sulfide (MoS2) films", & WEAR 1983, 91(3), 281-8
THIN SOLID FILMS, Band 124, Nr. 1, Februar 1985, Seiten 75-83, Elsevier Sequoia, Lausanne, CH, printed in NL; R. BICHSEL et al.: "Electrical and optical

(73) Patentinhaber: **Deutsche Forschungs- und Versuchsanstalt für Luft- und Raumfahrt e.V., D-5300 Bonn (DE)**

(72) Erfinder: **Buck, Volker, Dr., Halweg 41, D-4320 Hattingen (DE)**

(74) Vertreter: **Hoeger, Stellrecht & Partner, Uhlandstrasse 14c, D-7000 Stuttgart 1 (DE)**

(56) Entgegenhaltungen: (Fortsetzung)
properties of MoSe2 films prepared by R.F. magnetron sputtering"
CHEMICAL ABSTRACTS, Band 72, 1970, Seite 381, Zusammenfassung Nr. 71522u, Columbus, Ohio, US; M. FUJIMORI et al.: "Phase-forming processes in tantalum films through sputtering", & FUITSU SCI. TECH. J. 1969, 5(4), 123-55

**Beschreibung**

Die Erfindung betrifft ein Verfahren zum Aufbringen einer MoS$_2$-Beschichtung auf ein Substrat, bei dem man in einer Sputterkammer MoS$_2$-Moleküle in einer Gasentladung aus einem MoS$_2$-Target freisetzt und auf dem Substrat niederschlägt (Sputtern).

Molybdändisulfid-Sputterschichten können als Festschmierstoffe eingesetzt werden und finden insbesondere in der Raumfahrt umfangreiche Verwendung, da diese Schmierschichten im Vakuum des Weltalls eingesetzt werden können, wo der Einsatz von flüssigen Schmierstoffen (Ölen) wegen der Kriecheigenschaften nicht mehr möglich ist.

Von wesentlicher Bedeutung ist die Oxidationsbeständigkeit bei molybdändisulfidgeschmierten Teilen. Molybdändisulfid-Sputterschichten oxidieren beim Kontakt mit Feuchtigkeit, so dass bei der Raumfahrt aufwendige Schutzmassnahmen notwendig sind, z.B. Spülen mit trockenem Stickstoff, solange sich diese Molybdändisulfid-Schichten noch in der Erdatmosphäre befinden.

Molybdändisulfid-Sputterschichten bilden auf den beschichteten Oberflächen normalerweise Lamellen, deren Orientierung im wesentlichen senkrecht zur Substratoberfläche stehen. Dadurch ergibt sich eine höhere Oberfläche und damit eine höhere Oxidationsanfälligkeit bei Kontakt mit Feuchtigkeit. Bisher werden diese im wesentlichen senkrecht zur Substratoberfläche angeordneten Lamellen durch mechanische Bearbeitung, z.B. durch Abwischen, umorientiert, so dass die Lamellen dann zumindest in ihrem oberen Bereich im wesentlichen parallel zur Substratoberfläche verlaufen (Asle-Proceedings, Denver, Colorado, 7. bis 10. August 1984, Vortrag von Spalvins, Seiten 201 bis 207; Wear, 91 (1983), Artikel V. Buck, Seiten 281 bis 288). Bei diesem Verfahren brechen aber die Lamellen in der Regel leicht ab. Ausserdem kann mit dieser Methode trotzdem die grosse Oberfläche nur geringfügig vermindert werden, so dass weiterhin in korrosiven Medien eine grosse Angriffsfläche gegeben ist.

Die Herstellung flächenparallel verlaufender Lamellen ist beim Sputtern bisher nur in einem Fall durch den Einsatz eines ganz bestimmten Targets aus Molybdändisulfid erreicht worden, wobei die Ursachen für das Auftreten dieser bevorzugten Schichtform bisher unbekannt sind (Asle-Proceedings, Denver, Colorado, 7. bis 10. August 1984, Vortrag Fleischauer et al, Seiten 223 bis 229.)

Es ist Aufgabe der Erfindung, bekannte Sputterverfahren zum Beschichten eines Substrates mit einer Molybdändisulfid-Sputterschicht so zu verbessern, dass bei beliebigen Targets eine flächenparallele Orientierung der Lamellen erzeugt wird.

Diese Aufgabe wird bei einem Verfahren der eingangs beschriebenen Art erfindungsgemäss dadurch gelöst, dass man den Wasserdampfpartialdruck in der Sputterkammer so weit herabsetzt, dass das Verhältnis des Wasserdampfpartialdruckes zur Beschichtungsrate des Substrates bei $10^{-7}$ mbar/1,6 mg m$^{-2}$ s$^{-1}$ oder darunter liegt.

Dieses Verhältnis ist überraschend klein, d.h. es hat sich gezeigt, dass ein ausserordentlich geringer Wasserdampfpartialdruck eingestellt werden muss.

Es ist noch nicht geklärt, warum bereits geringe Wasserdampfpartialdrücke in der Sputterkammer eine flächenparallele Anordnung der Molybdändisulfid-Lamellen verhindern, jedoch könnte dies daran liegen, dass bereits eine geringe Oxidation des Molybdändisulfides aufgrund der geänderten Moleküldimensionen zu der unerwünschten Orientierung senkrecht zur Substratoberfläche führt.

Es hat sich überraschenderweise gezeigt, dass allein durch eine sehr weitgehende Herabsetzung des Wasserdampfpartialdruckes diese unerwünschte Umorientierung der Lamellen vermieden werden kann, so dass reproduzierbar flächenparallele Lamellenstrukturen gebildet werden.

Zur Herabsetzung des Wasserdampfpartialdruckes ist es günstig, wenn man vor dem Sputtern die Sputterkammer ausheizt.

Es ist auch möglich, vor dem Sputtern die Sputterkammer mit hoher Pumpleistung für Wasserdampf zu evakuieren, wobei dieser Evakuierungsvorgang über einen längeren Zeitraum (z.B. einige Stunden) erfolgen sollte.

Weiterhin wird im Rahmen des vorliegenden Verfahrens vorgeschlagen, dass die Sputterkammer über eine Vakuumschleuse beschickt wird, so dass ein unerwünschter Kontakt mit der wasserdampfhaltigen Umgebung weitgehend ausgeschaltet wird.

Günstig ist es auch, wenn man die zum Sputtern erforderliche Gasentladung mit einer mittleren Leistung betreibt, die einerseits eine ausreichende Sputterrate liefert, die aber andererseits keine zu hohe Wasserdesorption am Target hervorruft. Es hat sich nämlich herausgestellt, dass bei einer Erhöhung der Leistung der Gasentladung nicht nur mehr Molybdändisulfidteilchen aus dem Target freigesetzt werden, sondern auch mehr Wassermoleküle, wobei die Freisetzung der Wassermoleküle mit steigender Entladungsleistung stärker zunimmt als die Zahl der freigesetzten Molybdändisulfid-Teilchen. Daher ist der durch die Desorption auftretende Wasserdampfgehalt bei niedrigeren Entladungsleistungen relativ niedriger; allerdings können natürlich die Entladungsleistungen nicht so niedrig gewählt werden, dass eine ungenügende Sputterrate erzeugt wird. Wesentlich ist jedoch, dass die Entladungsleistung nicht zu hoch gewählt wird, dass also insgesamt der Sputtervorgang über einen längeren Zeitraum ausgedehnt wird.

Weiterhin lässt sich der Wasserdampfpartialdruck in der Sputterkammer dadurch niedrig halten, dass als Entladungsgas ein sorgfältig von Wasserdampf befreites Gas verwendet wird, beispielsweise Argon, welches über ein Molekularsieb und über einen Getter-Ofen geleitet worden ist.

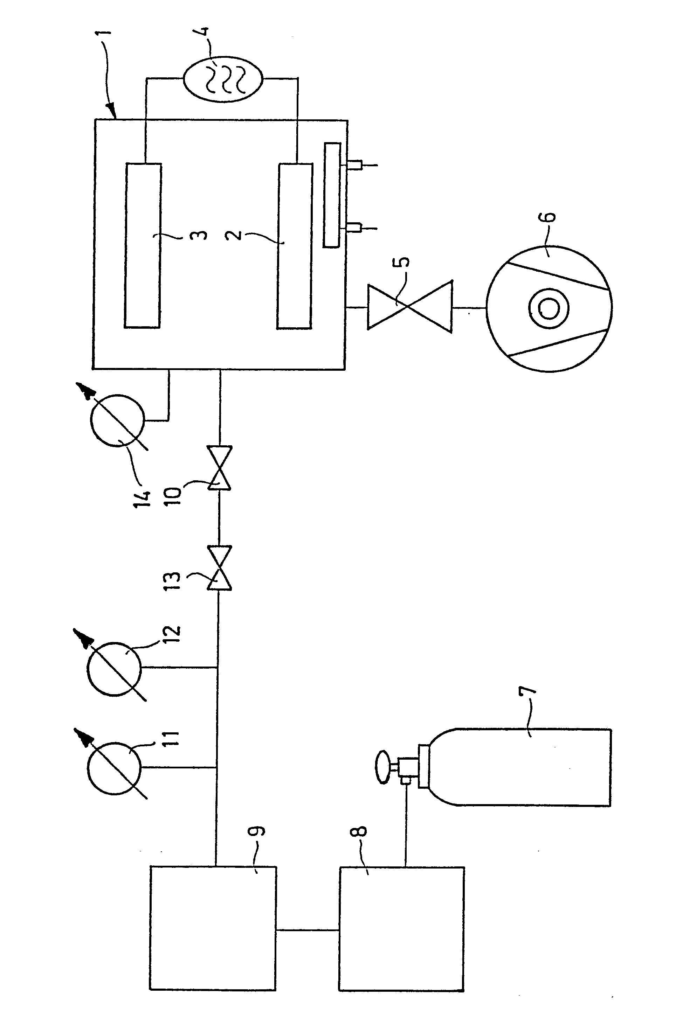

Die nachfolgende Beschreibung bevorzugter Ausführungsformen der Erfindung dient im Zusammenhang mit der Zeichnung der näheren Erläuterung. Die Zeichnung zeigt schematisch eine Anordnung zur Durchführung des Sputterverfahrens.

In einer allseits geschlossenen Sputterkammer 1 werden das zu beschichtende Teil, das im folgenden als Substrat 2 bezeichnet wird, und das Beschichtungsmaterial Molybdändisulfid, im folgenden als Target 3 bezeichnet, einander gegenüberliegend angeordnet, z.B. mit einem gegenseitigen Abstand von 4 cm. Das Target kann eine kompakte Scheibe aus Molybdändisulfid mit einem Durchmesser von 20 cm sein, das zu beschichtende Substrat weist ähnliche Abmessungen auf.

Substrat und Target bilden die Elektroden für eine Gasentladung, sie sind zu diesem Zweck jeweils mit einer Wechselspannungsquelle 4 verbunden.

Zur Evakuierung der Sputterkammer 1 ist diese über ein Ventil 5 mit einer Pumpe 6 verbunden, die vorzugsweise als Turbopumpe mit hoher Saugleistung ausgebildet ist, insbesondere hoher Saugleistung für Wasserdampf.

Als Entladungsgas wird im dargestellten Ausführungsbeispiel Argon verwendet, welches aus einer Vorratsflasche 7 über ein Molekularsieb 8 und einen Getter-Ofen 9 über ein Ventil 10 in die Sputterkammer 1 eingeleitet wird. Zwischen dem Getter-Ofen 9 und dem Ventil 10 sind noch ein Durchflussmessgerät 11, ein Feuchtigkeitsmessgerät 12 sowie ein Dosierventil 13 angeordnet. Molekularsieb und Getter-Ofen dienen der Reinigung des Argon, insbesondere der Reinigung von Wasserdampf, so dass das Argongas mit einem ausserordentlich geringen Wassergehalt in die Sputterkammer eingeleitet werden kann.

Der Wasserdampfgehalt im Inneren der Sputterkammer lässt sich mittels eines Partialdruckanlysators 14 bestimmen, vorzugsweise mittels eines Massenspektrometers.

Im Betrieb wird die Sputterkammer nach dem Beschicken, das vorzugsweise über eine in der Zeichnung nicht dargestellte Vakuumschleuse erfolgt, mittels der Pumpe 6 über einen längeren Zeitraum evakuiert und ausserdem ausgeheizt. Im Betrieb beträgt der Druck des in der Sputterkammer befindlichen Argon beispielsweise 20 µbar, der Wasserdampfpartialdruck kann beispielsweise bei $5 \times 10^{-9}$ mbar liegen.

Die Gasentladung kann beispielsweise mit einer Leistung von 750 W betrieben werden, so dass sich insgesamt eine Beschichtungsrate einstellt, bei der das Verhältnis von Wasserdampfpartialdruck zu Beschichtungsrate $10^{-7}$ mbar/1,6 mg m$^{-2}$s$^{-1}$ liegt.

Es hat sich herausgestellt, dass bei der Durchführung des Verfahrens mit den angegebenen niedrigen Wasserdampfpartialdrücken reproduzierbar Schichtstrukturen erreicht werden können, bei denen die Lamellen flächenparallel zur Substratfläche gebildet werden und nicht senkrecht dazu. Durch die wesentlich geringere Oberfläche, die die Lamellen der Umgebung bieten, ist die Oxidationsbeständigkeit solcher Molybdändisulfidschichten wesentlich grösser als die von Schichten mit senkrecht zur Substratoberfläche angeordneten Lamellen.

## Patentansprüche

1. Verfahren zum Aufbringen einer Molybdändisulfid-Beschichtung auf ein Substrat, bei dem man in einer Sputterkammer Molybdändisulfid in einer Gasentladung aus einem Molybdändisulfid-Target freisetzt und auf dem Substrat niederschlägt (Sputtern), dadurch gekennzeichnet, dass man den Wasserdampfpartialdruck in der Sputterkammer so weit herabsetzt, dass das Verhältnis des Wasserdampfpartialdruckes zur Beschichtungsrate des Substrats bei $10^{-7}$ mbar/1,6 mg m$^{-2}$s$^{-1}$ oder darunter liegt.

2. Verfahren nach Anspruch 1, dadurch gekennzeichnet, dass man zur Herabsetzung des Wasserdampfpartialdruckes vor dem Sputtern die Sputterkammer oder Teile davon ausheizt.

3. Verfahren nach einem der Ansprüche 1 oder 2, dadurch gekennzeichnet, dass man zur Herabsetzung des Wasserdampfpartialdruckes die Sputterkammer mit hoher Pumpleistung für Wasserdampf evakuiert.

4. Verfahren nach einem der voranstehenden Ansprüche, dadurch gekennzeichnet, dass man zur Herabsetzung des Wasserdampfpartialdruckes die Sputterkammer über eine Vakuumschleuse beschickt.

5. Verfahren nach einem der voranstehenden Ansprüche, dadurch gekennzeichnet, dass man zur Herabsetzung des Wasserdampfpartialdruckes die zum Sputtern erforderliche Gasentladung mit einer mittleren Leistung betreibt, die einerseits eine ausreichende Sputterrate liefert, die aber andererseits keine zu hohe Wasserdesorption am Target hervorruft.

6. Verfahren nach einem der voranstehenden Ansprüche, dadurch gekennzeichnet, dass man zur Herabsetzung des Wasserdampfpartialdruckes als Entladungsgas ein sorgfältig von Wasserdampf befreites Gas verwendet.

## Claims

1. Method for depositing a molybdenum disulphide coating on a substrate, in which, in a sputtering chamber, molybdenum disulphide is liberated in a gas discharge from a molybdenum disulphide target and deposited on the substrate (sputtering), characterised in that the water vapour partial pressure in the sputtering chamber is reduced so far that the ratio of the water vapour partial pressure to the coating rate of the substrate is $10^{-7}$ mbar/1.6 mg m$^{-2}$s$^{-1}$ or below.

2. Method according to Claim 1, characterised in that in order to reduce the water vapour partial pressure, the sputtering chamber or parts thereof are heated before sputtering.

3. Method according to one of Claims 1 or 2, characterised in that in order to reduce the water vapour partial pressure, the sputtering chamber is evacuated with a high pumping capacity for water vapour.

4. Method according to one of the preceding Claims, characterised in that in order to reduce the water vapour partial pressure, the sputtering chamber is filled by way of an airlock.

5. Method according to one of the preceding Claims, characterised in that in order to reduce the water vapour partial pressure, the gas discharge necessary for sputtering is operated at average capacity, which on the one hand produces a sufficient sputtering rate, but which on the other hand does not cause any excessive desorption of water on the target.

6. Method according to one of the preceding Claims, characterised in that in order to reduce the water vapour partial pressure, a gas from which the vapour has been carefully removed, is used as the discharge gas.

## Revendications

1. Procédé pour le dépôt d'un revêtement de disulfure de molybdène sur un substrat, dans lequel on libère du disulfure de molybdène à partir d'une cible de disulfure de molybdène dans une décharge gazeuse dans une chambre de pulvérisation cathodique et on le dépose sur un substrat (pulvérisation cathodique), caractérisé en ce que l'on abaisse la pression partielle de la vapeur d'eau dans la chambre de pulvérisation cathodique jusqu'à ce que le rapport de la pression partielle de vapeur d'eau à la vitesse de revêtement du substrat soit de $10^{-7}$ mbar/1,6 mg $m^{-2}s^{-1}$.

2. Procédé selon la revendication 1, caractérisé en ce que pour l'abaissement de la pression partielle de la vapeur d'eau, on chauffe la chambre de pulvérisation cathodique ou des parties de celle-ci avant la pulvérisation cathodique.

3. Procédé selon la revendication 1 ou 2, caractérisé en ce que pour l'abaissement de la pression partielle de la vapeur d'eau, on fait le vide dans la chambre de pulvérisation cathodique avec une capacité de pompage élevée pour la vapeur d'eau.

4. Procédé selon l'une des revendications précédentes, caractérisé en ce que pour l'abaissement de la pression partielle de la vapeur d'eau, on charge la chambre de pulvérisation cathodique par l'intermédiaire d'un sas à vide.

5. Procédé selon l'une des revendications précédentes, caractérisé en ce que pour l'abaissement de la pression partielle de la vapeur d'eau, on effectue la décharge gazeuse nécessaire pour la pulvérisation cathodique avec une puissance moyenne qui donne d'une part une vitesse de pulvérisation cathodique suffisante, mais qui d'autre part ne provoque pas une désorption de l'eau trop élevée sur la cible.

6. Procédé selon l'une des revendications précédentes, caractérisé en ce que pour l'abaissement de la pression partielle de la vapeur d'eau, on utilise comme gaz de décharge un gaz soigneusement débarrassé de vapeur d'eau.